# EUROPEAN PATENT APPLICATION

(11) **EP 2 790 279 A1**
(43) Date of publication of application: **15.10.2014**
(21) Application number: 12854588.6
(22) Date of filing: 30.11.2012
(51) Int. Cl.: H01S 5/02, H01L 21/301, H01S 5/343

(54) **METHOD FOR MANUFACTURING SEMICONDUCTOR LASER ELEMENT, AND SEMICONDUCTOR LASER ELEMENT**

(30) Priority: 08.12.2011 JP 2011269030
(71) Applicant: Sony Corporation, Tokyo 108-0075 (JP); Sumitomo Electric Industries, Ltd., Osaka-shi, Osaka 541-0041 (JP)
(72) Inventor: HAMAGUCHI Tatsushi, Minato-ku, Tokyo 108-0075 (JP); TAKAGI Shimpei, Osaka-shi, Osaka 554-0024 (JP)
(74) Representative: Müller - Hoffmann & Partner
(86) International application number: PCT/JP2012/081051
(87) International publication number: WO 2013/084807

(57) **Abstract**

In a method of manufacturing a semiconductor laser device (100) of an embodiment of the present disclosure, a cutting guide groove (104) is formed on a surface of a production substrate (110) in which an epitaxial layer (2) including a luminous layer (14) is formed on a hexagonal-system group III nitride semiconductor substrate (1) having a semi-polar plane (1a). At this time, the cutting guide groove (104) extending along a scribe line (BL1) and being V-shaped in cross section is formed in a partial region being on a scribe line (BL1) on a resonator-end-face side (102, 103) of the semiconductor laser device (100) and including one or more corners of the semiconductor laser device (100). Then, the production substrate (110) formed of the cutting guide groove (104) is cut along the scribe line (BL1).

## Description

### Technical Field

The disclosure relates to a method of manufacturing a semiconductor laser device and a semiconductor laser device manufactured by this method. The disclosure particularly relates to a method of manufacturing a hexagonal-system group III nitride semiconductor laser device and a semiconductor laser device manufactured by this method.

### Background Art

Currently, semiconductor laser devices are used in various technical fields. The semiconductor laser devices are indispensable optical devices, for example, in the field of image display units such as TVs and projectors, in particular. In this type of use, a semiconductor laser device that outputs light of red, green, and blue which are three primary colors of light is necessary. Semiconductor laser devices of red and blue have already been put to practical use. In recent years, development of semiconductor laser devices of green (with a wavelength of about 500 to 560 nm) has also been active (see, for example, NPL 1 and NPL2).

In each of NPL 1 and NPL 2, a hexagonal-system group III nitride semiconductor laser device is proposed. In this semiconductor laser device, an n-type cladding layer, a luminous layer including an active layer made of InGaN, and a p-type cladding layer are formed in this order on a semi-polar plane {2, 0, -2, 1} of an n-type GaN substrate. It is to be noted that, in this specification, an orientation of a hexagonal system crystal will be denoted by {h ,k, l, m} (h, k, 1, and m are plane indices (Miller indices)).

A semiconductor laser device such as that described above is manufactured by stacking various laser forming films (i.e. by causing epitaxial growth) on a semi-polar plane of a semiconductor substrate. In this type of semiconductor laser device, an end face orthogonal to a propagation direction (a guided-wave direction) of a laser beam is provided, and this is used as a reflecting surface (this end face will be hereinafter referred to as a "resonator end face"). Thus, various techniques of forming the resonator end face have been proposed for the semiconductor laser device using the semiconductor substrate having the semi-polar plane (see, for example, PTL 1).

In PTL 1, at first, a plurality of laser structures are formed on a semi-polar plane of a semiconductor substrate made of a hexagonal-system group III nitride semiconductor (i.e. a substrate product is produced). Next, using a laser scriber, scribe grooves are formed in a predetermined direction of the substrate product. Subsequently, a blade is pressed along each of the scribe grooves from the back surface of the substrate product, so that the substrate product is cut to be separated into a plurality of members. In the manufacturing method of PTL 1, an end face formed by this cutting of the substrate product is used as a resonator end face.

It is to be noted that, for the cutting of the nitride semiconductor laser device, various techniques have been proposed (see, for example, PTL 2). In PTL 2, cutting of a nitride semiconductor laser device is performed by the following procedure. First, a wafer is produced. This wafer is provided with a plurality of nitride semiconductor layers in which resonator surfaces are formed. Next, a first auxiliary groove shaped like a dashed line is formed. The first auxiliary groove is formed in a region, which is a part of a wafer region between the nitride semiconductor layers adjacent to each other and extends in the same direction as an extending direction of the resonator surface. The first auxiliary groove is formed in a direction parallel to the extending direction of the resonator surface. Subsequently, a second auxiliary groove deeper than the first auxiliary groove is formed. The second auxiliary groove is formed in a region, which is a part of a wafer region between the nitride semiconductor layers adjacent to each other and is orthogonal to the extending direction of the resonator surface. The second auxiliary groove is formed in a direction perpendicular to the extending direction of the resonator surface. The wafer is then divided along the first auxiliary groove and the second auxiliary groove.

### Citation list

### Patent Literature

PTL 1: Japanese Patent No. 4475357
PTL 2: Japanese Unexamined Patent Application Publication No. 2010-199482 Non-Patent Literature
NPL 1: Kyono et al.: "The world's First True Green Laser Diodes on Novel Semi-Polar GaN Substrates I", SEI technical review, No. 176, pp. 88-92 (January, 2010)
NPL 2: Adachi et al.: "The world's First True Green Laser Diodes on Novel Semi-Polar GaN Substrates II", SEI technical review, No. 176, pp. 93-96 (January, 2010)

### Summary of the Invention

As described above, there have been proposed various methods of manufacturing the semiconductor laser device using the semiconductor substrate having the semi-polar plane. In this technical field, however, it is expected to develop a technique of manufacturing a semiconductor laser device with excellent laser characteristics, by further enhancing orthogonality between a propagation direction of a laser beam and a resonator end face, as well as improving surface smoothness of the resonator end face.

Therefore, it is desirable to provide a method of manufacturing a semiconductor laser device using a semiconductor substrate having a semi-polar plane, and to provide the semiconductor laser device, the semiconductor laser device being capable of further improving orthogonality and surface smoothness of a resonator end face.

A method of manufacturing a semiconductor laser device of an embodiment of the present disclosure is performed in the following procedure. First, a production substrate is prepared on a hexagonal-system group III nitride semiconductor substrate having a semi-polar plane, the production substrate having an epitaxial layer that includes a luminous layer of a semiconductor laser device. Next, a cutting guide groove is formed on a surface of the production substrate. At this time, the cutting guide groove is formed on the partial region being on a scribe line on a resonator-end-face side of the semiconductor laser device and including one or more corners of the semiconductor laser device, and the cutting guide groove being formed in an extending direction along the scribe line and being V-shaped in cross section when viewed from the extending direction. Then, the production substrate in which the cutting guide groove is formed is cut along the scribe line.

It is to be noted that "the cutting guide groove being V-shaped in cross section" here is a cutting guide groove having a shape in which a bottom of the cutting guide groove has an acute shape, and includes not only a cutting guide groove which is completely V-shaped in cross section, but a cutting guide groove which is substantially V-shaped in cross section.

Further, a semiconductor laser device of an embodiment of the present disclosure includes a semiconductor base substrate, an epitaxial layer, an electrode and a slope section and each of the structure is as follows. The semiconductor base substrate is formed of a hexagonal-system group III nitride semiconductor and has a semi-polar plane. The epitaxial layer includes a luminous layer that forms an optical waveguide of a laser beam and is formed on the semiconductor base substrate. The electrode is formed on the epitaxial layer. In addition, the slope section is formed in a partial region that includes one or more corners of a resonator end face of a laser structure including the semiconductor base substrate and the epitaxial layer, the one or more corners being on the epitaxial layer side, the resonator end face being orthogonal to a propagation direction of the laser beam, and is inclined towards a surface of the laser structure, the surface being on the epitaxial layer side.

Furthermore, a semiconductor laser device of an embodiment of the present disclosure is the semiconductor laser device manufactured by the above-mentioned method of manufacturing the semiconductor laser device of the embodiment of the present disclosure.

In the method of manufacturing the semiconductor laser device according to the embodiment of the present disclosure, the resonator end face is formed by cutting the production substrate of the semiconductor laser device through use of the cutting guide groove which is V-shaped in cross section. Using this method, orthogonality between the propagation direction of the laser beam and the resonator end face, as well as surface smoothness of the resonator end face are allowed to be improved. Therefore, according to the present disclosure, laser characteristics of the semiconductor laser device, which employs the semiconductor substrate (a semi-polar substrate) having the semi-polar plane, are allowed to be improved.

### Brief Description of Drawings

[FIG. 1] FIG. 1 is a schematic perspective diagram of a semiconductor laser device according to an embodiment of the disclosure.
[FIG. 2A] FIG. 2A is a diagram illustrating an example of a polar plane in a crystal structure of GaN.
[FIG. 2B] FIG. 2B is a diagram illustrating an example of a non-polar plane in the crystal structure of GaN.
[FIG. 3] FIG. 3 is a diagram illustrating an example of a semi-polar plane in the crystal structure of GaN.
[FIG. 4] FIG. 4 is a schematic cross-sectional diagram of the semiconductor laser device according to the embodiment of the disclosure.
[FIG. 5] FIG. 5 is a flowchart illustrating a procedure of a method of manufacturing the semiconductor laser device according to the embodiment of the disclosure.
[FIG. 6] FIG. 6 is a schematic plan view of a production substrate of the semiconductor laser device produced in the embodiment of the disclosure.
[FIG. 7] FIG. 7 is a diagram used to describe an example of a technique of forming a cutting guide groove.
[FIG. 8] FIG. 8 is a diagram used to describe the example of the technique of forming the cutting guide groove.
[FIG. 9] FIG. 9 is a diagram used to describe the example of the technique of forming the cutting guide groove.
[FIG. 10] FIG. 10 is a diagram used to describe the example of the technique of forming the cutting guide groove.
[FIG. 11] FIG. 11 is a diagram used to describe the example of the technique of forming the cutting guide groove.
[FIG. 12] FIG. 12 is a diagram used to describe the example of the technique of forming the cutting guide groove.
[FIG. 13] FIG. 13 is a diagram used to describe the example of the technique of forming the cutting guide groove.
[FIG. 14] FIG. 14 is a diagram illustrating an example of a schematic perspective cross-sectional view of the cutting guide groove.
[FIG. 15] FIG. 15 is an example of a cross-sectional photograph of the cutting guide groove when viewed from an extending direction of the cutting guide groove.
[FIG. 16] FIG. 16 is a diagram illustrating a relationship between an angle of inclination from the c-plane of each of various crystal planes in the crystal structure of GaN and a plane index defining an orientation.
[FIG. 17] FIG. 17 is a diagram illustrating an example of a schematic plan view of the cutting guide groove.

### Description of Embodiments

An example of each of a semiconductor laser device and a method of manufacturing the same according to an embodiment of the disclosure will be described in the following order, with reference to the drawings. The disclosure is, however, not limited to the following examples.
1. Configuration of Semiconductor Laser Device
2. Technique of Manufacturing Semiconductor Laser Device
3. Configuration of Cutting Guide Groove
4. Example

### <1. Configuration of Semiconductor Laser Device>

### [Overall Configuration of Semiconductor Laser Device]

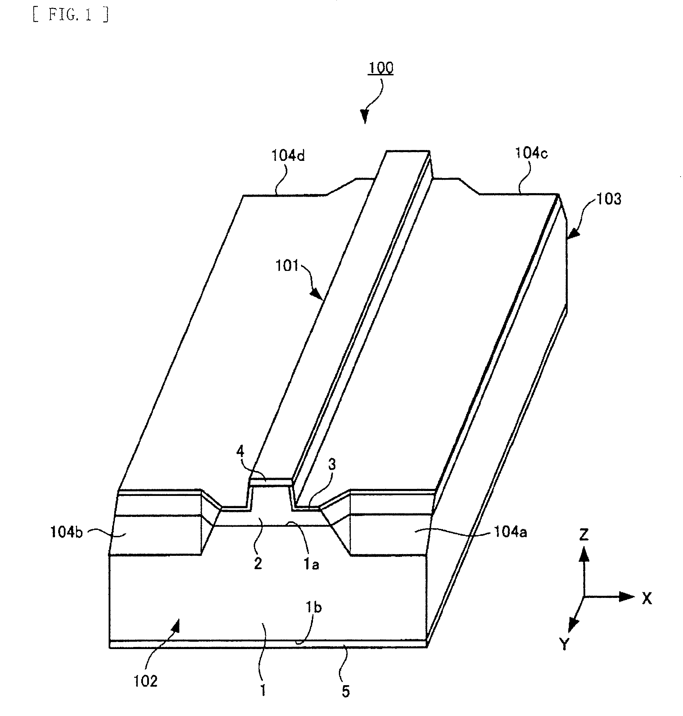

FIG. 1 illustrates a schematic external view of a semiconductor laser device (a semiconductor laser device 100) according to an embodiment of the disclosure. It is to be noted that, in an example illustrated in FIG. 1, the semiconductor laser device 100 of ridge type (refractive index guiding type) is depicted, but the disclosure is not limited thereto. For example, the technology of the disclosure which will be described below is applicable to a semiconductor laser device of gain guiding type.

The semiconductor laser device 100 includes a semiconductor base substrate 1, an epitaxial layer 2, an insulating layer 3, a first electrode 4 (an electrode), and a second electrode 5.

In the semiconductor laser device 100 of the present embodiment, one surface 1a (a top surface in FIG. 1) of the semiconductor base substrate 1 is a semi-polar plane, and the epitaxial layer 2, the insulating layer 3, and the first electrode 4 are formed in this order on this semi-polar plane 1a. On a surface 1b (an undersurface in FIG. 1, which will be hereinafter referred to as a "back surface 1b") opposite the semi-polar plane 1a of the semiconductor base substrate 1, the second electrode 5 is formed. It is to be noted that, when a semi-polar plane in the neighborhood of a {2, 0, -2, 1} plane is used as the semi-polar plane 1a of the semiconductor base substrate 1, green light having a wavelength of approximately 500 nm is allowed to be oscillated, for example.

Further, as illustrated in FIG. 1, the semiconductor laser device 100 is substantially shaped like a rectangular solid. A stripe section 101 having a ridge structure and extending in a predetermined direction (a Y direction in FIG. 1) is formed on a surface of the semiconductor laser device 100, the surface being on the first electrode 4 side. The stripe section 101 is formed to extend from one side face 102 which will be described later to the other side face 103 of the semiconductor laser device 100. An extending direction of the stripe section 101 serves as a propagation direction of a laser beam. Of the epitaxial layer 2, a region corresponding to the stripe section 101 serves as an optical waveguide.

In the present embodiment, the extending direction of the stripe section 101 is assumed to be a direction orthogonal to an a-axis direction. However, the extending direction of the stripe section 101 is allowed to be set as appropriate, depending on, for example, conditions such as a use and necessary laser characteristics, without being limited to this example. It is to be noted that a width of the stripe section 101 is about a few micrometers or less, and an extension length (a cavity length) of the stripe section 101 is about a few hundred micrometers.

Further, the semiconductor laser device 100 has four side faces (end faces). Among these four side faces, the two side faces 102 and 103 (cut surfaces) orthogonal to the extending direction (the Y direction in FIG. 1) of the stripe section 101 each act as a reflecting surface of a laser resonator. In other words, the two side faces 102 and 103 are resonator end faces, and the laser resonator is configured of the two side faces 102 and 103 as well as an optical waveguide region, which corresponds to the stripe section 101, of the epitaxial layer 2. It is to be noted that, as will be described later, the semiconductor laser device 100 is produced by being cut out from a substrate member (this will be hereinafter referred to as a "production substrate") in which a plurality of the semiconductor laser devices 100 are arranged two-dimensionally. Therefore, these four side faces are cut sections formed in that cutting.

It is to be noted that, in the semiconductor laser device 100 of the present embodiment, a dielectric multilayer film made of a SiO₂/TiO₂ film or the like is formed (by end-face coating) on a surface of one or both of the two resonator end faces 102 and 103. It is possible to adjust a reflectance on the resonator end face, by performing the end-face coating.

Furthermore, the semiconductor laser device 100 has four slope sections 104a to 104d. The slope sections 104a to 104d are respectively formed at four corners of the surface of a laser structure configured to include the semiconductor base substrate 1, the epitaxial layer 2, and the insulating layer 3. This surface is on the stripe section 101 side (i.e. the top surface in the example of FIG. 1). Each of these slope sections 104a to 104d is a part (a remaining part) of one of sidewall surfaces, the sidewall surfaces defining a cutting guide groove. The cutting guide groove is provided on a scribe line extending in a direction (an X direction in FIG. 1) along each of the resonator end faces, in the production substrate of the semiconductor laser device 100. The cutting guide groove is substantially V-shaped in cross section. In other words, each of the slope sections 104a and 104b is a remaining part of one of the sidewall surfaces, and each of the slope sections 104c and 104d is a remaining part of the other of the sidewall surfaces.

It is to be noted that, when, for example, the semi-polar plane 1a has an orientation in the neighborhood of a {2, 0, -2, 1} plane, a {0, 0 ,0, 1} plane (i.e. "c-plane") is mainly exposed on one of the slope section 104a (104b) and the slope section 104c (104d), as will be described later. In this case, as will be described later, the ratio between the width of the slope section where the c-plane is not exposed and the width of the slope section where the c-plane is exposed, in the extending direction (the Y direction in FIG. 1, which is a groove-width direction of the cutting guide groove) of the stripe section 101, is about 6:4. In other words, there is established such a state that the ratio between the width of the slope section 104a (104b) and the width of the slope section 104c (104d) is offset from a 1:1 ratio.

### [Configuration of Each Section]

Here, a configuration of each component of the semiconductor laser device 100 of the present embodiment will be described more in detail.

### (1) Semiconductor Base Substrate

The semiconductor base substrate 1 is formed of, for example, a hexagonal-system group III nitride semiconductor such as GaN, AlN, AlGAN, InGAN, and InAlGaN. Further, as the semiconductor base substrate 1, a substrate in which the conductivity type of a carrier is of an n-type may be used. Further, in the present embodiment, the one surface, on which the epitaxial layer 2, the insulating layer 3, and the first electrode 4 are formed, of the semiconductor base substrate 1, is the semi-polar plane 1a as described above.

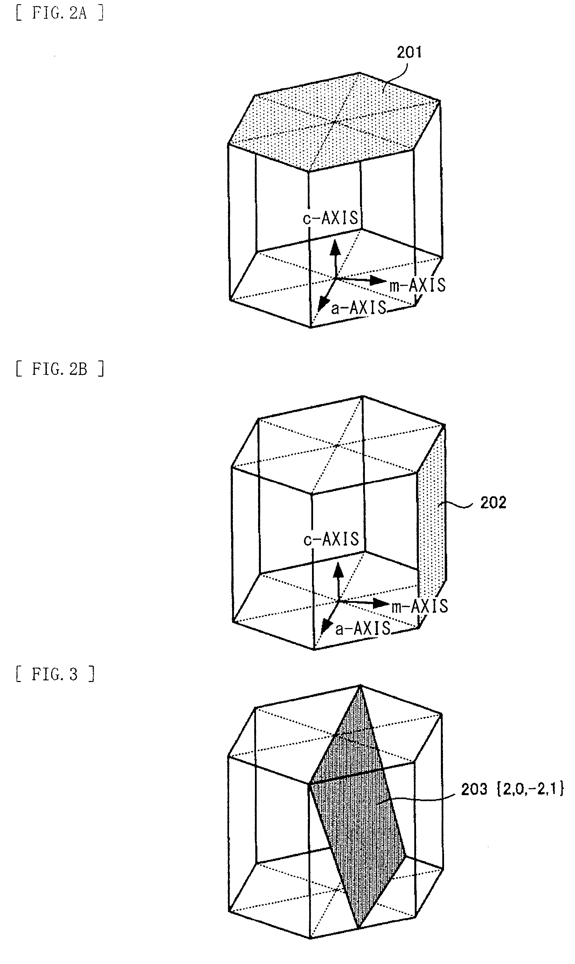

Here, a crystal structure of GaN is illustrated in FIGs. 2A and 2B as well as FIG. 3. GaN has a crystal structure called a hexagonal crystal as illustrated in FIGs. 2A and 2B. Since a piezoelectric field in a luminous layer 14, which will be described later, within the epitaxial layer 2 is generated along a c-axis, a c-plane 201 (the {0, 0, 0, 1} plane) orthogonal to the c-axis has a polarity and is called a polar plane. Meanwhile, an m-plane 202 (a {1, 0, -1, 0} plane) orthogonal to an m-axis is parallel with the c-axis and thus is nonpolar, and called a nonpolar plane. In contrast, a plane in which an axis direction realized by inclining the c-axis towards an m-axis direction by a predetermined angle is the normal direction is a middle plane between the c-plane and the m-plane, and called a semi-polar plane. In the example of FIG. 3, this middle plane is a plane (a {2, 0, -2, 1} plane 203) in which an axis direction realized by inclining the c-axis towards the m-axis direction by about 75 degrees is the normal direction.

It is to be noted that, for example, a crystal plane in which a direction realized by inclining the c-axis towards the m-axis direction by about 45 to 80 degrees or by 100 to 135 degrees is the normal direction may be used as the semi-polar plane 1a. Further, in the above-mentioned angular ranges, an angle between the normal direction of the semi-polar plane 1 a and the c-axis is preferably, for example, 63 to 80 degrees or 100 to 117 degrees, in order to achieve light emission of a long wavelength. In these angular ranges, piezopolarization in the luminous layer (an active layer), which will be described later, in the epitaxial layer 2 decreases, and at the same time, incorporation of In at the time of the growth (formation) of the luminous layer improves. Thus, an In-composition variable range in the luminous layer is allowed to be increased. Therefore, setting the above-described angular ranges for the angle between the normal direction of the semi-polar plane 1a and the c-axis makes it easy to obtain the light emission of a long wavelength.

As the semi-polar plane 1a having the normal direction within the above-described angular ranges, there may be used, for example, a crystal plane such as a {2, 0, -2, 1} plane, a {1, 0, -1, 1} plane, a {2, 0, -2, -1} plane, and a {1, 0, -1, -1} plane. It is to be noted that a crystal plane slightly inclined plus or minus 4 degrees from any of these crystal planes may also be used as the semi-polar plane 1a. When any of these crystal planes is used as the semi-polar plane 1a, it is possible to form the resonator end faces 102 and 103 which are sufficiently excellent in surface smoothness and orthogonality.

It is to be noted that, as will be described later, when the cutting guide groove is provided in the production substrate in a manufacturing process as in the present embodiment, and the extending direction thereof is used as the a-axis direction, it is preferable that the semi-polar plane 1a, in which the normal direction is a direction realized by inclining the c-axis towards the m-axis direction by about 60 to 90 degrees, be used as the semi-polar plane 1a. In this case, the substantially V-shaped cutting guide groove is allowed to be obtained with excellent reproducibility and stability, as will be described later.

Further, the thickness of the semiconductor base substrate 1 may be set, for example, about 400 µm or less. In this thickness range, it is possible to obtain the resonator end faces (cut surfaces) 102 and 103 of high quality (i.e. with excellent surface smoothness and orthogonality), at the time of cutting the production substrate of the semiconductor laser device.

### (2) Epitaxial Layer, Insulating Layer, First Electrode, and Second Electrode

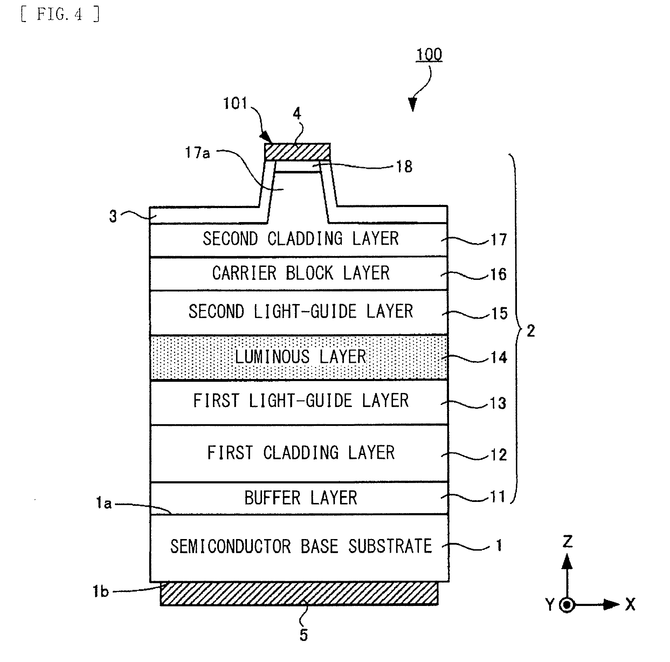

Next, there will be described a configuration of the epitaxial layer 2, the insulating layer 3, the first electrode 4, and the second electrode 5 of the semiconductor laser device 100 in the present embodiment, with reference to FIG. 4. FIG. 4 is a schematic cross-sectional diagram of the semiconductor laser device 100 taken along a thickness direction (a Z direction in the figure). It is to be noted that FIG. 4 illustrates a cross section orthogonal to the extending direction (the Y direction in the figure) of the stripe section 101.

In the present embodiment, the epitaxial layer 2 includes a buffer layer 11, a first cladding layer 12, a first light-guide layer 13, the luminous layer 14 (the active layer), a second light-guide layer 15, a carrier block layer 16, a second cladding layer 17, and a contact layer 18. The buffer layer 11, the first cladding layer 12, the first light-guide layer 13, the luminous layer 14, the second light-guide layer 15, the carrier block layer 16, the second cladding layer 17, and the contact layer 18 are stacked in this order on the semi-polar plane 1 a of the semiconductor base substrate 1. It is to be noted that, here, there will be described an example in which the semiconductor base substrate 1 is configured using an n-type GaN semi-polar substrate.

The buffer layer 11 may be configured using, for example, a gallium nitride-based semiconductor layer such as an n-type GaN layer. The first cladding layer 12 may be configured using, for example, a gallium nitride-based semiconductor layer such as an n-type AlGaN layer and an n-type InAlGaN layer. The first light-guide layer 13 may be configured using, for example, a gallium nitride-based semiconductor layer such as an n-type GaN layer and an n-type InGaN layer.

The luminous layer 14 is configured of a well layer (not illustrated) and a barrier layer (not illustrated). The well layer is formed of, for example, a gallium nitride-based semiconductor such as InGaN and InAlGaN. The barrier layer is formed of, for example, a gallium nitride-based semiconductor such as GaN, InGaN, and InAlGaN. It is to be noted that the luminous layer 14 may have, for example, a multiquantum well structure in which a well layer and a barrier layer are alternately stacked to form a plurality of layers. It is to be noted that the luminous layer 14 serves as a light emission region of the epitaxial layer 2, and emits light of, for example, a wavelength in a range of about 480 nm to about 550 nm.

The second light-guide layer 15 may be configured using a gallium nitride-based semiconductor layer in which the conductivity type of a carrier is a p-type. Examples of this gallium nitride-based semiconductor layer include a p-type GaN layer and a p-type InGaN layer. The carrier block layer 16 (an electron block layer) may be configured using, for example, a p-type AlGaN layer.

The second cladding layer 17 may be configured using, for example, a gallium nitride-based semiconductor layer such as a p-type AlGaN layer and a p-type InAlGaN layer. It is to be noted that, since the semiconductor laser device 100 of the present embodiment is the semiconductor laser device of ridge type, a region of the second cladding layer 17, except a region corresponding to the stripe section 101 on the surface on the first electrode 4 side, is lowered by etching or the like. As a result, a ridge section 17a is formed in the region of the second cladding layer 17, the region corresponding to the stripe section 101 on the surface on the first electrode 4 side. It is to be noted that, in a manner similar to the stripe section 101, the ridge section 17a is formed to extend in the direction substantially orthogonal to each of the resonator end faces. The ridge section 17a is also formed to extend from the one resonator end face 102 to the other resonator end face 103.

The contact layer 18 may be configured using, for example, a p-type GaN layer. In addition, the contact layer 18 is formed on the ridge section 17a of the second cladding layer 17.

The insulating layer 3 is configured using, for example, an insulating film such as a SiO₂ film. The insulating layer 3 is formed on the region except the ridge section 17a of the second cladding layer 17, as well as on side faces of each of the ridge section 17a and the contact layer 18, as illustrated in FIG. 4.

The first electrode 4 (a p-side electrode) may be configured using, for example, a conductive film such as a Pd film. In addition, the first electrode 4 is formed on the contact layer 18, as well as on end faces of the insulating layer 3, the end faces being on the contact layer 18 side. It is to be noted that, in the semiconductor laser device 100 of the present embodiment, an electrode film for a pad electrode may be provided to cover the insulating layer 3 and the first electrode 4.

The second electrode 5 (an n-side electrode) may be configured using, for example, a conductive film such as an Al film. In addition, the second electrode 5 is formed on the back surface 1b of the semiconductor base substrate 1.

### <2. Technique of Manufacturing Semiconductor Laser Device>

### (1) Overall Flow of Technique of Manufacturing Semiconductor Laser Device

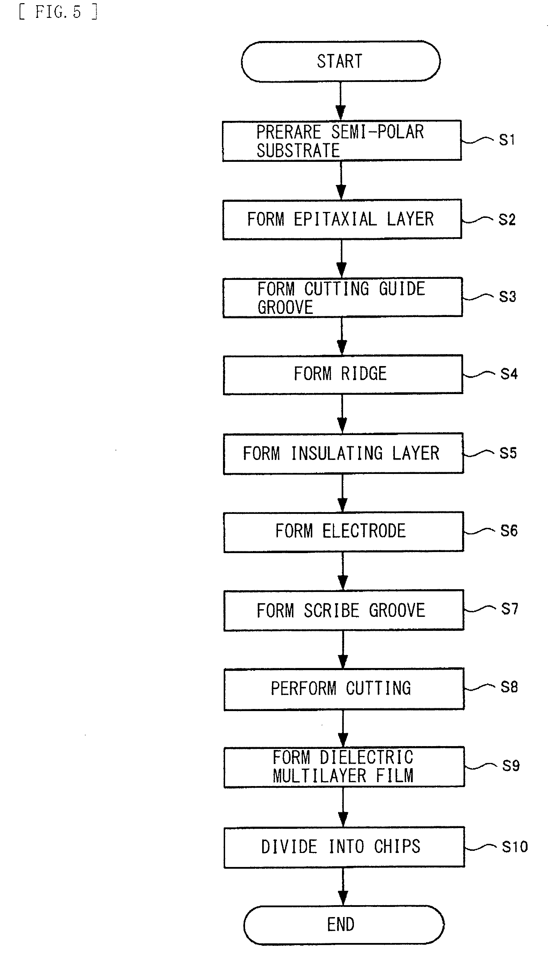

Next, a technique of manufacturing the semiconductor laser device 100 of the present embodiment will be specifically described with reference to FIG. 5. It is to be noted that FIG. 5 is a flowchart indicating an overall procedure of the technique of manufacturing the semiconductor laser device 100. Further, in the present embodiment, there will be described an example in which a dielectric multilayer film is formed (by end-face coating) on each of the resonator end faces of the semiconductor laser device 100.

First, a semi-polar substrate (a semiconductor substrate having a semi-polar plane) formed of a hexagonal-system group III nitride semiconductor is prepared (step S1). The semi-polar substrate is used to two-dimensionally arrange and form the plurality of semiconductor laser devices 100. The semi-polar substrate is then subjected to thermal cleaning.

Next, various semiconductor films are epitaxially grown in predetermined order on the semi-polar plane of the semi-polar substrate, by using, for example, a technique such as OMVPE (organicmetallic vapor phase epitaxy), so that a semiconductor film group forming the epitaxial layer 2 is formed (step S2). Specifically, the semiconductor films which respectively form the buffer layer 11, the first cladding layer 12, the first light-guide layer 13, the luminous layer 14, the second light-guide layer 15, the carrier block layer 16, the second cladding layer 17, and the contact layer 18 are epitaxially grown in this order on the semi-polar plane.

Next, the cutting guide groove is formed in a surface, which is on the semiconductor film group side, of a substrate member where the semiconductor film group is formed (step S3). The cutting guide groove is formed along a border (a scribe line) between regions of the respective two semiconductor laser devices 100 adjacent to each other in the propagation direction of the laser beam. In this step, the cutting guide groove is formed by etching, for example. In other words, the cutting guide groove is formed in the surface, which is on the semiconductor film group side, of the substrate member, along the border (the border on the resonator-end-face side) in a direction orthogonal to the propagation direction of the laser beam (i.e. the extending direction of the stripe section 101).

It is to be noted that, in this step, on the surface on the semiconductor film group side of the semi-polar substrate, the cutting guide groove is formed in a partial region including one or more corners of the semiconductor laser device 100. In addition, in the present embodiment, the stripe section 101 is formed to cross the border on the resonator-end-face side, but the cutting guide groove is formed not to intersect the stripe section 101, as will be described later. In other words, in step S3, the cutting guide groove is formed intermittently along the border on the resonator-end-face side.

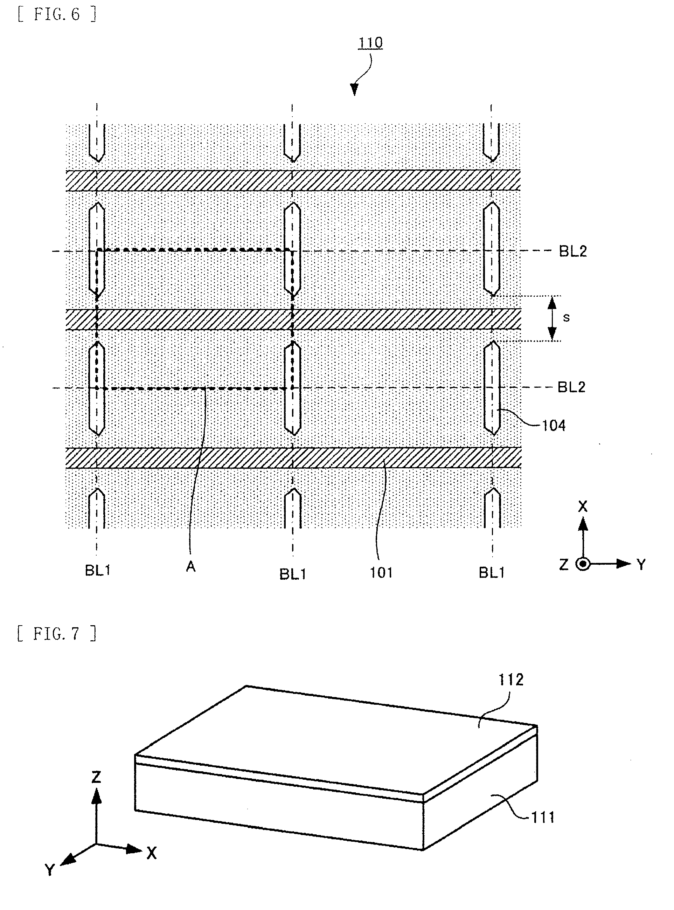

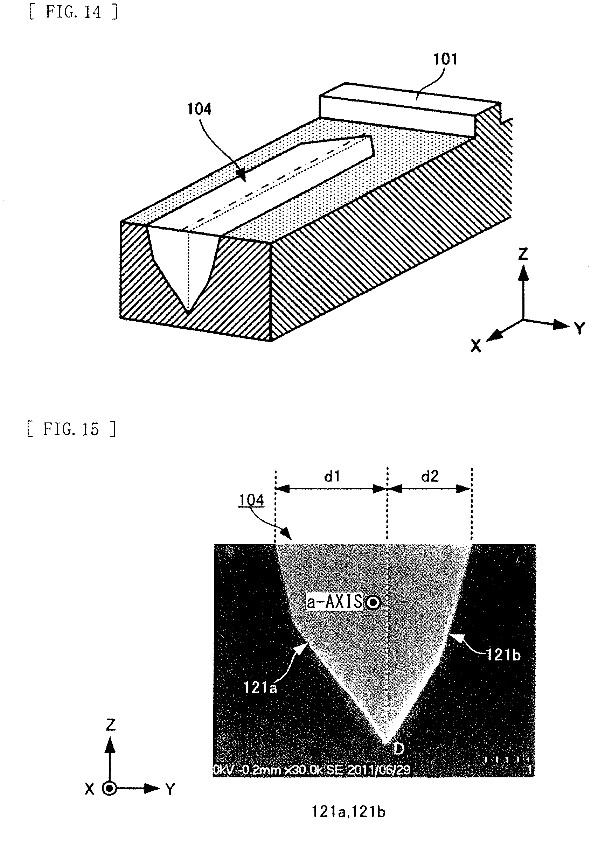

Further, as will be described later, the cutting guide groove formed in the step S3 is substantially V-shaped in a planar view when viewed from the extending direction of the cutting guide groove (see FIG. 14 which will be described later). Furthermore, in the present embodiment, an end (a tip) of the cutting guide groove, the end being on the stripe section 101 side, is also substantially V-shaped in a planar view, when viewed from the normal direction (the Z direction) of the surface of the semi-polar substrate, the surface being on the semiconductor film group side (see FIGs. 6 and 14 which will be described later).

Moreover, the width of the cutting guide groove formed in the step S3 may be set in a range of about 1.0 µm to about 10 µm, more preferably, in a range of about 1.5 µm to about 2.5 µm. Further, the depth of the cutting guide groove may be set, for example, in a range of about 0.5 µm to about 30 µm, more preferably, in a range of about 1.0 µm to 4.about 0 µm. It is to be noted that a technique of forming the cutting guide groove will be described later in detail.

Next, a mask is formed in a region where the stripe section 101 is to be formed, of a surface region of the semi-polar substrate. The surface region is on the side where the semiconductor film forming the contact layer 18 is provided. Subsequently, a region except the region where the mask is formed is etched, so that a ridge is formed on the surface of each of the semiconductor laser devices 100, the surface being on the contact layer 18 side (step S4).

It is to be noted that, in this step, the region except the region where the stripe section 101 is formed is etched from the surface of the contact layer 18 to a predetermined depth of the second cladding layer 17, so that the ridge is formed in the region where the stripe section 101 is to be formed. In addition, in this step, the ridge is continuously formed along the extending direction of the stripe section 101 to cross the border between the resonance end faces, in the region between the two semiconductor laser devices 100 which are adjacent to each other in the extending direction of the stripe section 101 (see FIG. 6 which will be described later).

Next, upon removal of the mask on the ridge, an insulating film forming the insulating layer 3 is formed on a surface, which is on the ridge side, of the semi-polar substrate, by using, for example, a technique such as vacuum deposition and sputtering (step S5). It is to be noted that the mask on the ridge may be removed after the formation of the insulating film. Further, when the mask is formed of a metal or the like, the mask may be used as a part of the first electrode 4 and thus, in this case, the removal of the mask is unnecessary.

Subsequently, an electrode film is formed on the substrate member where the various semiconductor films and the insulating film have been formed in the semi-polar substrate as described above (step S6). This electrode film forms each of the first electrode 4 and the second electrode 5.

Specifically, the electrode film forming the first electrode 4 (i.e. a first electrode film) is formed as follows. First, the insulating film on each of the ridges is removed using a photolithography technique, so that the contact layer 18 is exposed on the surface. Next, on each of the exposed contact layers 18, for example, the electrode film forming the first electrode 4 is formed using, for example, a technique such as deposition and sputtering.

On the other hand, the electrode film forming the second electrode 5 (i.e. a second electrode film) is formed follows. First, the back surface of the semi-polar substrate is polished to set the thickness of the semi-polar substrate to a desired thickness. Next, the electrode film forming the second electrode 5 is formed over the entire back surface of the semi-polar substrate, by using, for example, a technique such as deposition and sputtering.

In the present embodiment, the production substrate where the plurality of semiconductor laser devices 100 are two-dimensionally arranged and formed is produced through the steps S 1 to S6 described above.

Here, FIG. 6 illustrates a schematic plan view of the production substrate produced through the steps S1 to S6 described above, when viewed from the first electrode 4 side. It is to be noted that FIG. 6 illustrates only a partial region of the production substrate, to simplify the description. Further, a region A surrounded by a thick dotted line in FIG. 6 is a region where the one semiconductor laser device 100 is formed.

In addition, a dashed line BL1 in FIG. 6 is a line indicating a border between the two regions A adjacent to each other in the extending direction (the Y direction) of the stripe section 101, each of the regions A being formed with the semiconductor laser device 100. In other words, the border BL1 is the border on the resonator-end-face side. The border BL1 on the resonator-end-face side in FIG. 6 corresponds to the scribe line used in forming each of the resonator end faces.

Furthermore, a broken line BL2 in FIG. 6 is a line indicating a border between the two regions A adjacent to each other in the direction (the X direction) orthogonal to the extending direction of the stripe section 101, each of the regions A being formed with the semiconductor laser device 100 (the broken line BL2 will be hereinafter referred to as the "border BL2 on the side-face side"). In other words, the border BL2 on the side-face side in FIG. 6 corresponds to the scribe line used in forming each of the side faces of the semiconductor laser device 100. These side faces are parallel with the extending direction of the stripe section 101. Then, when each of the semiconductor laser devices 100 is cut out as a chip from the production substrate 110, the production substrate 110 is cut along the border BL1 on the resonator-end-face side and the border BL2 on the side-face side.

In the present embodiment, the cutting guide grooves 104 are intermittently formed along each of the borders BL1 on the resonator-end-face side, in the plane of the production substrate 110, as illustrated in FIG. 6. In this process, each of the cutting guide grooves 104 is continuously formed along an extending direction of the border BL1, in a region between the two stripe sections 101 that are adjacent to each other in the extending direction (the X direction) of the border BL1. Further, in this process, each of the cutting guide grooves 104 is formed not to intersect the region where the stripe section 101 is formed. A distance "s" between the two cutting guide grooves 104, which are adjacent to each other with the stripe section 101 interposed in between, is set as appropriate, depending on, for example, the type of a process or the shape of a film formed therearound.

It is to be noted that, in the present embodiment, there has been described the example where the cutting guide groove 104 is provided for every region between the two stripe sections 101 adjacent to each other in the direction (the X direction) along the border BL1 on the resonator-end-face side. In other words, there has been described the example where the cutting guide groove 104 is provided in the regions on both sides of each of the stripe sections 101, in the direction (the X direction) along the border BL1. However, the disclosure is not limited to this example.

For instance, the cutting guide groove 104 may be formed either in a region on one side or a region on the other side of each of the stripe sections 101, in the direction (the X direction) along the border BL1 on the resonator-end-face side. In this case, the cutting guide grooves 104 may be aligned and each formed in the region on the one side or the region on the other side of each of the stripe sections 101, along all the borders BL1. Alternatively, the cutting guide grooves 104 may be formed such that the positions where the respective cutting guide grooves 104 are formed, the positions being relative to the stripe section 101, may be alternate for every border BL1.

Moreover, in the present embodiment, the shape of the cutting guide groove 104, when viewed from the first electrode 4 side of the production substrate, has linear symmetry with respect to the border BL2 on the side-face side, as illustrated in FIG. 6. However, the disclosure is not limited to this shape. The shape of the cutting guide groove 104 may be asymmetrical with respect to the border BL2. For instance, the groove length from the border BL2 to one tip of the cutting guide groove 104 may be different from the groove length from the border BL2 to the other tip of the cutting guide groove 104.

Here, referring back to FIG. 5, there will be described a procedure of processing in or after step S7, i.e. processing of cutting out each of the semiconductor laser devices 100 from the production substrate 110 illustrated in FIG. 6 (namely, cutting). It is to be noted that a technique similar to those ordinary (for example, the PTL 1 mentioned above) may be used for the processing of cutting out each of the semiconductor laser devices 100. In the following, a technique using a laser scribe device (not illustrated) will be described.

First, the production substrate 110 produced as described above is attached to the laser scribe device. A part of the border BL1 on the resonator-end-face side, in which each of the cutting guide grooves 104 of the production substrate 110 is formed, is irradiated with a laser beam, so that a scribe groove is formed (step S7). Specifically, for example, the scribe groove is formed on the border BL near an edge of the production substrate 110, along the extending direction of the border BL1. It is to be noted that since the scribe groove is formed by being irradiated with the laser beam, the width and the depth of the scribe groove are significantly larger than those of the cutting guide groove 104 formed by, for example, semiconductor processing such as etching.

Next, a breaking device (not illustrated) called a blade is pressed against a part on the back surface of the production substrate 110, the part being in a region facing the region where the scribe groove is formed, so that the production substrate 110 is cut (cleaved) along the border BL1 on the resonator-end-face side (step S8). This cutting is performed for each of the borders BL1, so that the production substrate 110 is divided into a plurality of substrate members. In this process, a part in the neighborhood of the stripe section 101 is cut along the cutting guide groove 104. The cutting guide groove 104 has the groove width sufficiently narrower than that of the scribe groove and is substantially V-shaped in cross section. Thus, concentration of a large stress on a specific small region is enabled and therefore, the resonator end face is allowed to be accurately formed at a desired position in the neighborhood of the stripe section 101. This makes it possible to obtain the resonator end face with excellent surface smoothness and orthogonality.

Next, the dielectric multilayer film is formed on a cut surface (the resonator end face) of each of the substrate members separated in the step S8 (step S9). Then, lastly, each of the substrate members is cut along an extending direction of the border BL2 on the side-face side of each of the substrate members, so that each of the substrate members is divided into the plurality of semiconductor laser devices 100 as the chips (step S10).

In the present embodiment, the semiconductor laser device 100 is produced as described above. In the present embodiment, as described above, the production substrate 110 is cut along each of the cutting guide grooves 104 in the step S8. Therefore, in the semiconductor laser device 100 cut out from the production substrate 110, a part of one or the other of the sidewall surfaces defining the cutting guide groove 104 remains, in the vicinity of each of the corners of the surface on the first electrode 4 side. Thus, the slope sections 104a to 104d as illustrated in FIG. 1 are formed.

### (2) Technique of Forming Cutting Guide Groove

Next, a procedure in a technique of forming the cutting guide groove 104 performed in the step S3 in the flowchart illustrated in FIG. 5 will be described with reference to FIGs. 7 to 13. It is to be noted that, FIGs. 7 to 13 are schematic perspective diagrams of the substrate member at the time of completion of the respective processes in the step S3. However, here, in order to simplify the description, there is illustrated only a region in the neighborhood of the border between the two regions adjacent to each other in the substrate member, each of the regions being formed with the semiconductor laser device 100.

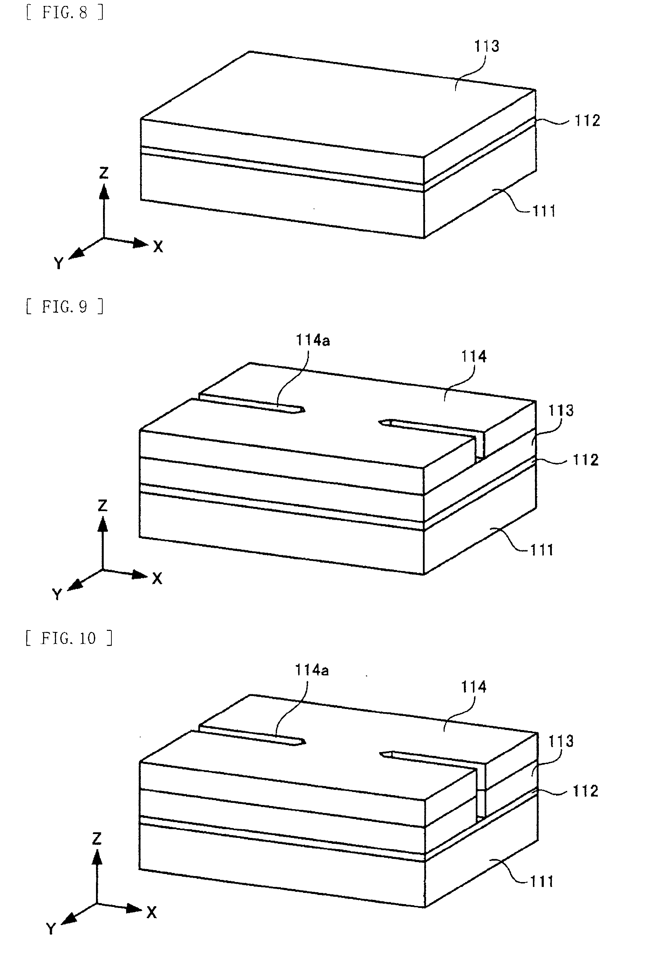

First, after the semiconductor film group 112 forming the epitaxial layer 2 is formed on the semi-polar substrate 111 in the step S2 (a state in FIG. 7), an etching mask 113 made of, for example, a SiO₂ film is formed on the semiconductor film group 112 as illustrated in FIG. 8. It is to be noted that the thickness of the etching mask 113 may be, for example, about 100 to about 1,000 nm.

Next, a resist film 114 is formed on the etching mask 113 as illustrated in FIG. 9. Then, a region of the resist film 114, the region corresponding to the region where each of the cutting guide grooves 104 is to be formed, is removed by a photolithography technique (patterning) used in an ordinary semiconductor process. As a result, in the resist film 114, an opening section 114a is formed in the region where each of the cutting guide grooves 104 is to be formed, resulting in a state in which the etching mask 113 is exposed in the opening section 114a (a state in FIG. 9). It is to be noted that the width of this opening section 114a is set to be the same as the width of the cutting guide groove 104.

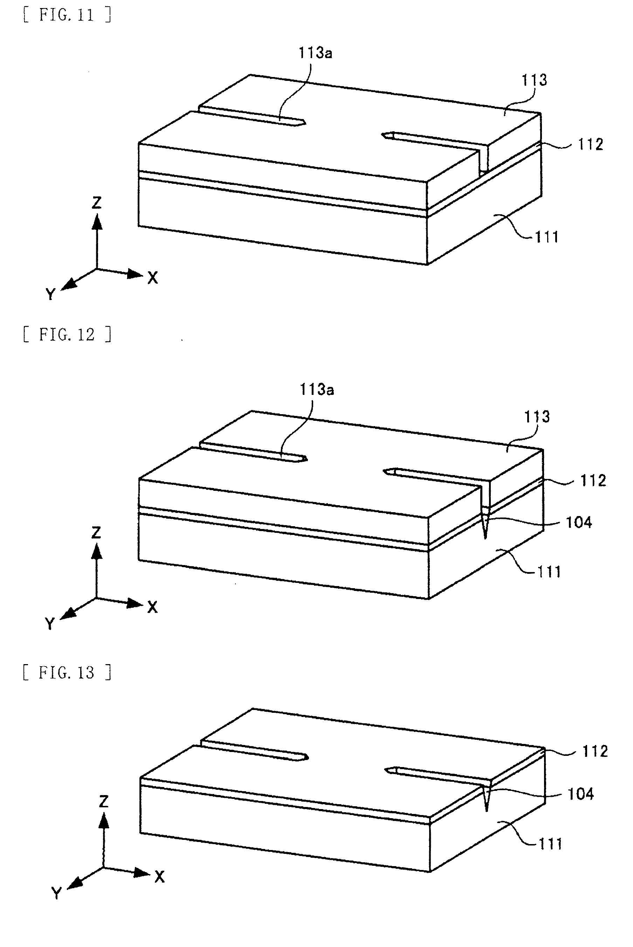

Subsequently, the etching mask 113 exposed in the opening section 114a of the resist film 114 is removed by etching, through RIE (Reactive Ion Etching) using, for example, a gas such as CF₄, or through wet etching using, for example, a hydrofluoric acid base solution or the like (a state in FIG. 10). It is to be noted that, in this process, the etching is performed until the semiconductor film group 112 forming the epitaxial layer 2 is exposed in the opening section 114a of the resist film 114. The resist film 114 is then removed (a state in FIG. 11).

Next, the cutting guide groove 104 is formed by etching a region of the semiconductor film group 112, the region being exposed in each opening section 113a of the etching mask 113 (a state in FIG. 12). The etching is performed through RIE using, for example, a single gas such as a Cl₂ gas and an Ar gas, or using a gas formed by mixing these gases. In this process, the etching is continued until the bottom of the cutting guide groove 104 reaches a desired depth of the semi-polar substrate 111. It is to be noted that, in this process, as will be described later, the cutting guide groove 104 which is substantially V-shaped in the cross section orthogonal to the extending direction of the groove is formed, due to characteristics (properties) in a crystal structure of the semi-polar substrate 111.

Next, the etching mask 113 is removed (a state in FIG. 13). In the present embodiment, after the cutting guide groove 104 is formed in the manner described above, the stripe section 101 is formed on the surface on the side where the semiconductor film group 112 forming the epitaxial layer 2 is provided, according to the procedure described with reference to the steps S4 to S6 in FIG. 5.

It is to be noted that, in the present embodiment, there has been described the case where the cutting guide groove 104 is formed after the semiconductor film group 112 forming the epitaxial layer 2 is formed on the semi-polar substrate 111 as described above. However, the disclosure is not limited to this case. For example, the cutting guide groove 104 may be formed using the above-described formation technique (FIGs. 7 to 13), after the stripe section 101 is formed (after the first electrode 4 and the second electrode 5 are formed). Alternatively, for instance, the cutting guide groove 104 may be formed using the above-described formation technique (FIGs. 7 to 13), after the ridge is formed in the semiconductor film group 112 forming the epitaxial layer 2. In this case, in the processes of FIGs. 12 to 13, the insulating film made of the SiO₂ film or the like used as the etching mask 113 may be utilized as a film of forming the insulating layer 3, without being removed.

In the present embodiment, the semiconductor laser device 100 is produced using the cutting guide groove 104 as described above. This allows the semiconductor laser device 100 excellent in laser characteristics to be obtained by a simpler technique. The reason therefor will be described below.

In order to obtain a higher-performance semiconductor laser device, it is necessary to improve the surface smoothness of each of resonator end faces forming a laser resonator, as well as the orthogonality between each of the resonator end faces and the propagation direction of a laser beam (equivalent to the extending direction of the stripe section 101). Therefore, various techniques of forming the resonator end faces have been proposed for the semiconductor laser device using a semi-polar substrate. In reality, however, it is difficult to form the resonator end faces having excellent surface smoothness and orthogonality. This is because, in the semiconductor laser device using the semi-polar substrate, there is a case in which the resonator end face is not an ordinary easy-to-cleave surface such as the c-plane, the m-plane, and the a-plane (see FIGs. 2A and 2B).

In contrast, in the present embodiment, separately from the scribe groove formed by the device such as the laser scriber, the cutting guide groove 104 is provided by the semiconductor process, in the region near the corner of the chip forming the semiconductor laser device 100. This region is on the scribe line in the direction along each of the resonator end faces. As described above, the cutting guide groove 104 provided in this process is finer than the scribe groove, and is substantially V-shaped in the cross section orthogonal to the extending direction thereof. Further, in the process of cutting out the chip forming the semiconductor laser device 100 from the production substrate 110, large stress is exerted on the cutting guide groove 104. Thus, an end face region in the neighborhood of the stripe section 101 is cut along this cutting guide groove 104.

Therefore, in the manufacturing technique of the present embodiment, the resonator end face (in particular, the end face region in the neighborhood of the stripe section 101) is accurately formed at a desired position, which allows suppression of variations in the positions of the resonator end faces. As a result, it is possible to further improve the surface smoothness of each of the resonator end faces, as well as the orthogonality between each of the resonator end faces and the extending direction of the stripe section 101 (i.e. the propagation direction of the laser beam). With this manufacturing technique, for example, laser oscillation is allowed to be efficiently performed by a lower oscillation threshold current, and the semiconductor laser device 100 superior in laser characteristics is achievable.

### <3. Configuration of Cutting Guide Groove>

Here, a configuration and characteristics of the cutting guide groove 104 formed in the present embodiment will be described in greater detail with reference to some drawings.

FIG. 14 illustrates a schematic configuration of the cutting guide groove 104 formed in the present embodiment. It is to be noted that FIG. 14 is a perspective cross-sectional diagram schematically illustrating the cutting guide groove 104.

In the present embodiment, as illustrated in FIG. 14, the shape of the bottom of the cutting guide groove 104 is substantially shaped like a letter V forming an acute angle, and the shape of an end of the cutting guide groove 104, the end being on the stripe section 101 side, is also substantially shaped like a letter V. The shape of the cutting guide groove 104 will be described below more in detail.

### (1) Shape of Sidewall Surface of Cutting Guide Groove

First, there will be described the shape of the sidewall surfaces defining the cutting guide groove 104 (i.e. the sidewall surfaces that extend along the extending direction of the cutting guide groove 104). FIG. 15 illustrates a cross-sectional photograph of the cutting guide groove 104 actually formed. It is to be noted that the section illustrated in FIG. 15 is orthogonal to the extending direction of the cutting guide groove 104 (i.e. the X direction: crystallographically, the a-axis direction).

As apparent from FIG. 15, the cutting guide groove 104 in the present embodiment is substantially V-shaped in a planar view, when viewed from the extending direction thereof. Further, the shape of the bottom of the cutting guide groove 104 is substantially shaped like a letter V forming an acute angle.

Furthermore, the angle of inclination of the one sidewall surface 121 a (the sidewall surface on the left in FIG. 15) defining a part of the substantially V-shaped cutting guide groove 104 is smaller than that of the other sidewall surface 121b (the sidewall surface on the right in FIG. 15), as apparent from FIG. 15. As a result, a deepest section D of the cutting guide groove 104 is at a position shifted (offset) from the center of the cutting guide groove 104 to the other sidewall surface 121b side, in the groove-width direction (the Y direction in FIG. 15). In other words, this is a state in which the ratio between a width d1 of the one sidewall surface 121 a and a width d2 of the other sidewall surface 121b in the groove-width direction is offset from a 1:1 ratio. It is to be noted that, in the example illustrated in FIG. 15, the ratio between the width d1 of the one sidewall surface 121a and the width d2 of the other sidewall surface 121b in the groove-width direction is about 6:4.

It is conceivable that the above-described characteristics of the cutting guide groove 104 may be ascribable to the fact that the semiconductor base substrate 1 is configured using the semi-polar substrate. The reason therefor will be described below. It is to be noted that, here, there will be described a case in which the semiconductor base substrate 1 is formed of GaN and the semi-polar plane 1a is the {2, 0, -2, 1} plane, i.e. a case in which the normal direction of the semi-polar plane 1a is a direction realized by inclining the c-axis towards the m-axis direction by about 75 degrees.

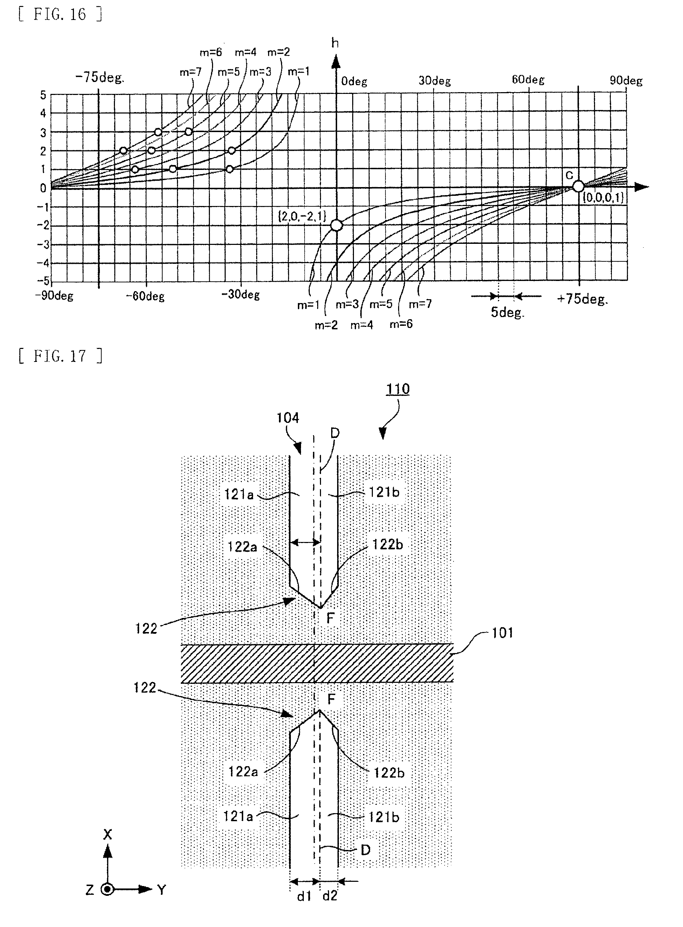

FIG. 16 illustrates a relationship between plane indices and angles of inclination of various crystal planes with respect to the c-plane of a GaN crystal. It is to be noted that, in the present embodiment, as described above, the extending direction of the cutting guide groove 104 is the a-axis (i.e. parallel with the a-axis). Therefore, the orientation of a crystal plane ({h, l, k, m}) capable of being exposed on the sidewall surface defining the cutting guide groove 104 is {h, 0, -h, m}. In other words, the orientation of the crystal plane capable of being exposed on the sidewall surface that defines the cutting guide groove 104 is expressed by two plane indices (variables) "h" and "m".

In the characteristics illustrated in FIG. 16, a horizontal axis indicates the angles of inclination, and a vertical axis indicates the plane indices "h". In addition, in FIG. 16, there is plotted the relationship between the plane indices and the angles of inclination of various crystal planes with respect to the c-plane, when the plane index "m" which is the other variable is varied from 1 to 7. In each graph illustrated in FIG. 16, a crystal plane exists at an intersection (a white circle in the figure) between the graph of each of the plane indices "m" and a horizontal line (a scale mark) where the plane index "h" is a constant integer. The angle of the intersection is the angle of inclination of the crystal plane with respect to the c-plane. However, here, since the orientation of the semi-polar plane 1a is assumed to be {2, 0, -2, 1}, the center of the horizontal axis of the graph is the {2, 0, -2, 1} plane in FIG. 16 instead of the c-plane, for convenience of description. Therefore, the angles of inclination in the horizontal axis in the characteristics illustrated in FIG. 16 are the angles of inclination of various crystal planes with respect to the {2, 0, -2, 1} plane.

Further, in FIG. 16, for convenience of description, crystal planes capable of being exposed on the right sidewall surface 121b and those of the left sidewall surface 121 a are brought into correspondence with the characteristic of the right quadrant and that of the left quadrant from the center of the horizontal axis in FIG. 16, respectively. These sidewall surfaces 121b and 121a define the cutting guide groove 104 illustrated in FIG. 15. In other words, in FIG. 16, the crystal planes in the right quadrant (a region with positive angles of inclination) from the center in the horizontal axis (the {2, 0, -2, 1} plane) represent the crystal planes capable of being exposed on the right sidewall surface 121b defining the cutting guide groove 104 in FIG. 15. On the other hand, in FIG. 16, the crystal planes in the left quadrant (a region with negative angles of inclination) from the center in the horizontal axis (the {2, 0, -2, 1} plane) represent the crystal planes capable of being exposed on the left sidewall surface 121a defining the cutting guide groove 104 in FIG. 15.

The c-plane (a {0, 0, 0, 1} plane) exists at a position inclined by plus 75 degrees with respect to the {2, 0, -2, 1} plane (the orientation of the semiconductor base substrate 1). However, in a region of plus or minus 10 degrees of the c-plane, there is no intersection between the graph of each of the plane indices "m" and the horizontal line where the plane index "h" is a constant integer, as apparent from FIG. 16. In other words, there is no middle-low-level crystal plane (the plane index "m" is 9 or less) in the region of plus or minus 10 degrees of the c-plane. From this, it is apparent that, mainly, the c-plane (the {0, 0, 0, 1} plane) is easily and stably exposed on the right sidewall surface 121b defining the cutting guide groove 104 in FIG. 15.

On the other hand, as illustrated in FIG. 16, in a region inclined by, for example, minus 35 to minus 80 degrees with respect to the {2, 0, -2, 1} plane, there are many intersections each between the graph of each of the plane indices "m" and the horizontal line where the plane index "h" is a constant integer. Thus, it is apparent that there is a plurality of middle-low-level crystal planes in this region. In other words, in the left sidewall surface 121a defining the cutting guide groove 104 in FIG. 15, a plurality of crystal planes each having a smaller angle of inclination than that of the right sidewall surface 121b are mixedly present, and thus, apparently, exposure of a stable crystal plane is difficult. Therefore, when the cutting guide groove 104 is formed in the semi-polar substrate by etching, a plurality of crystal planes each having a smaller angle of inclination in the one sidewall surface 121 a than that of the other sidewall surface 121b are readily formed, and thus, the inclination of the sidewall surface 121 a is gentle. In the other sidewall surface 121b, on the other hand, the c-plane is easily and stably exposed and thus, the inclination of the sidewall surface 121b is steeper than that of the one sidewall surface 121a.

As described above, in the present embodiment, the angles of inclination of the respective two sidewalls defining the cutting guide groove 104 are different from each other. Therefore, as illustrated in FIG. 15, there is formed the cutting guide groove 104 in which the deepest section D is substantially shaped like a letter V forming an extremely acute angle. In addition, since the angles of inclination of the respective two sidewalls defining the cutting guide groove 104 are different from each other, the position of the deepest section D of the cutting guide groove 104 is shifted from the center of the cutting guide groove 104 to the other sidewall surface 121b side, in the groove-width direction (the Y direction in FIG. 15).

In the present embodiment, as described above, since the cutting guide groove 104 is formed using the crystallographically asymmetry characteristic of the hexagonal (GaN) crystal, it is possible to form the grove substantially shaped like a letter V forming an extremely acute angle, as compared with a substantially V-shaped groove obtained by a technique without using such a crystallographic characteristic. Therefore, using the substantially V-shaped cutting guide groove 104 formed by the above-described manufacturing technique of the present embodiment, cutting accuracy (cleavage) of the semi-polar substrate is allowed to be further improved.

### (2) Suitable Range of Semi-polar Plane

As described above, when, for example, the semi-polar substrate of the {2, 0, -2, 1} plane is used, the c-plane exists at an angle inclined by about 75 degrees from the semi-polar plane (i.e. one of the sidewall surfaces is steep). Therefore, the cutting guide groove 104 which is substantially shaped like a letter V forming an acute angle is readily obtained. However, the orientation of the semi-polar substrate capable of being used is not limited to this example.

The c-plane is a crystallographically stable surface, and is easily exposed by, for example, a treatment such as dry etching and wet etching. Therefore, use of the semi-polar substrate having the orientation inclined at a steep angle with respect to the c-plane makes it easy to expose the c-plane on one or both of the sidewall surfaces defining the cutting guide groove 104, thereby allowing the inclination of the sidewall surface(s) to be steep. Here, the relationship between the substantially V-shaped cutting guide groove 104 as described above and the semi-polar plane (the face forming the epitaxial layer 2) of the semi-polar substrate (the semiconductor base substrate 1) will be described in greater detail.

When, for example, a structure such as the cutting guide groove 104 is formed in a GaN substrate by dry etching (RIE) using an etching gas such as a Cl₂ gas, the angle of a sidewall surface with respect to a substrate surface becomes about 70 to 80 degrees, without becoming perpendicular to the substrate surface in many cases. This is due to, for example, various factors such as adhesion of deposits produced during the etching to the sidewall surface of the groove. Therefore, when, in particular, a stable crystal plane is present at an angle in the neighborhood of about 70 to 80 degrees with respect to a semi-polar plane of a semi-polar substrate, there is a strong tendency of the crystal plane to be exposed on the sidewall surface of the cutting guide groove.

In the GaN substrate used in the present embodiment, the c-plane is one of particularly highly stable crystal planes among various crystal planes that exist in the GaN crystal. Further, as illustrated in FIG. 16, when the extending direction of the cutting guide groove is limited to the a-axis direction (when the crystal plane of the sidewall surface is limited to the crystal plane parallel to the a-axis direction), there is no middle-low-level crystal plane having an angle of inclination of plus or minus 10 degrees with respect to the c-plane (i.e. there is no crystal plane in which the plane index is 9 or less). Therefore, in a case where the cutting guide groove extending in the a-axis direction is formed by dry etching, it is possible to readily expose the c-plane on the sidewall surface, when there is the c-plane exposed in the cutting guide groove and falling within the range of plus or minus 10 degrees of the one of the sidewall surfaces, the one having an angle of inclination of about 70 to 80 degrees.

In other words, when the cutting guide groove 104 is formed along the a-axis direction by dry etching, through use of the semi-polar substrate having the semi-polar plane inclined at an angle greater than about 60 degrees and less than about 90 degrees with respect to the c-plane, there is a strong tendency of the c-plane to be exposed on one of the sidewall surfaces. Therefore, in this case, the substantially V-shaped cutting guide groove 104 is allowed to be stably obtained with excellent reproducibility.

### (3) Shape of Tip of Cutting Guide Groove

Next, the shape of the end (a tip) of the cutting guide groove 104 in the extending direction will be described. FIG. 17 illustrates a schematic plan view of the cutting guide groove 104 formed in the present embodiment. It is to be noted that FIG. 17 illustrates a configuration of only a region in the neighborhood of the stripe section 101.

In the present embodiment, the shape of the end (a tip 122) of the cutting guide groove 104, the end being on the stripe section 101 side, is assumed to be substantially V-shaped in a planar view when viewed from the normal direction (the Z direction) of the surface of the production substrate 110, as illustrated in FIG. 17.

The tip 122 of the cutting guide groove 104 is configured to include two front-end sidewall faces 122a and 122b (each of these will be hereinafter referred to a "front-end face"). The one front-end face 122a is formed along the extending direction (the X direction in FIG. 17) of the cutting guide groove 104, continuously to the one sidewall surface 121 a of the cutting guide groove 104. In addition, the other front-end face 122b is formed along the extending direction of the cutting guide groove 104, continuously to the other sidewall surface 121b of the cutting guide groove 104.

It is to be noted that, as described above, the ratio between the width d1 of the one sidewall surface 121a and the width d2 of the other sidewall surface 121b in the groove-width direction (the Y direction in FIG. 17) of the cutting guide groove 104 is offset from the 1:1 ratio (i.e. about 6:4 in the example of FIG. 17). Therefore, in the present embodiment, the ratio between the width of the one front-end face 122a and the width of the other front-end face 122b in the groove-width direction is also offset from a 1:1 ratio (set at about 6:4 in the example of FIG. 17). In other words, the position of an extreme-end section F of the cutting guide groove 104 is shifted (offset), in the groove-width direction, from the center (a dashed line in FIG. 17) to the other front-end face 122b side (i.e. towards the front-end face on the right in FIG. 17).

This makes it possible to improve parallelism between the extending direction of the deepest section D of the cutting guide groove 104 and the extending direction of the cutting guide groove 104 (the X direction in FIG. 17), namely, a cutting direction. In this case, in forming the resonator end faces by cutting the production substrate 110, the resonator end faces are allowed to be formed at desired positions with higher accuracy, and suppression of variations in the positions of the resonator end faces is enabled. In other words, in the present embodiment, the cutting of the production substrate 110 is allowed to be further improved by substantially shaping the tip 122 of the cutting guide groove 104 into a letter V.

However, the shape of the tip 122 of the cutting guide groove 104 is not limited to the example illustrated in FIG. 17. For instance, the shape of the tip 122 of the cutting guide groove 104 may be modified as appropriate, depending on conditions such as the width and the extending direction of the cutting guide groove 104. For example, the ratio between the width of the one front-end face 122a and the width of the other front-end face 122b in the groove-width direction may be set at about 1:1, depending on the above-mentioned conditions. Further, depending on the above-mentioned conditions, the tip 122 of the cutting guide groove 104 may be arc-shaped, linear (flat), or the like, in a planar view when viewed from the normal direction of the surface of the production substrate 110.

### <4. Example>

Now, there will be described an example (an Example) of the laser characteristics of the semiconductor laser device 100 actually produced by the above-described technique of manufacturing the semiconductor laser device 100, i.e. the manufacturing technique using the cutting guide groove 104. It is to be noted that, here, laser characteristics of a semiconductor laser device (a comparative example) produced without forming the cutting guide groove 104 were examined to make a comparison with the Example. It is to be noted that, in the Example, the cutting guide groove 104 having a groove width of 2 µm and a depth of 2 µm was formed in the production substrate, and the semiconductor laser device 100 was manufactured.

Results of measuring the laser characteristics in the semiconductor laser device of each of the Example and the comparative example are provided in the following Table 1.

**[Table 1]**

| | Oscillation Threshold Current Ith | |
|---|---|---|
| | Average (mA) | Variance (mA) |
| Example | 97 | 23 |
| Comparative Example | 159 | 44 |

As apparent from Table 1, the average and variance of the oscillation threshold current Ith of the semiconductor laser device 100 in the Example were both smaller than those of the comparative example. In other words, in the semiconductor laser device 100 of the Example, oscillation was enabled with a current lower than that in the comparative example. Also from this viewpoint, it is apparent that, in the semiconductor laser device 100 of the Example, there are improvements in the surface smoothness of the resonator end faces as well as the orthogonality of the resonator end faces with respect to the extending direction of the optical waveguide, as compared with those of the comparative example.

It is to be noted that the disclosure may be configured as follows.
(1)
   A method of manufacturing a semiconductor laser device, the method including:
   preparing a production substrate on a hexagonal-system group III nitride semiconductor substrate having a semi-polar plane, the production substrate having an epitaxial layer that includes a luminous layer of a semiconductor laser device;
   forming a cutting guide groove in a partial region on a surface of the production substrate, the partial region being on a scribe line on a resonator-end-face side of the semiconductor laser device and including one or more corners of the semiconductor laser device, and the cutting guide groove being formed in an extending direction along the scribe line and being V-shaped in cross section when viewed from the extending direction; and
   cutting, along the scribe line, the production substrate in which the cutting guide groove is formed.
(2)
   The method according to (1), wherein the hexagonal-system group III nitride semiconductor substrate is a semiconductor substrate having a semi-polar plane in which a direction realized by inclining a c-axis towards an m-axis at an angle in a range of about 60 to 90 degrees is a normal direction.
(3)
   The method according to (2), wherein the hexagonal-system group III nitride semiconductor substrate is a semiconductor substrate having a semi-polar plane in which a direction realized by inclining the c-axis towards the m-axis by about 75 degrees is a normal direction.
(4)
   The method according to (2) or (3), wherein the cutting guide groove in which a c-plane is exposed on one of two sidewall surfaces is formed, the two sidewall surfaces defining the cutting guide groove and being formed in a direction along the extending direction of the cutting guide groove.
(5)
   The method according to any one of (2) to (4), wherein there is formed the cutting guide groove in which a ratio between a width of one of the sidewall surfaces in a groove-width direction and a width of the other of the sidewall surfaces in the groove-width direction is offset from a 1:1 ratio.
(6)
   The method according to (5), wherein there is formed the cutting guide groove in which a tip of the cutting guide groove in the extending direction is V-shaped when viewed from a surface of the production substrate, the tip being defined by two front-end sidewall faces, one of the two front-end sidewall faces is formed continuously to the one of the sidewall surfaces, the other of the two front-end sidewall faces is formed continuously to the other of the sidewall surfaces, and a ratio between a width of the one of the two front-end sidewall faces in the groove-width direction and a width of the other of the two front-end sidewall faces in the groove-width direction is offset from a 1:1 ratio.
(7)
   The method according to any one of (1) to (6), wherein the cutting guide groove is formed to extend in an a-axis direction.
(8)
   The method according to any one of (1) to (7), wherein the cutting guide groove is formed by dry etching.
(9)
   A semiconductor laser device including:
   a semiconductor base substrate formed of a hexagonal-system group III nitride semiconductor, and having a semi-polar plane;
   an epitaxial layer including a luminous layer that forms an optical waveguide of a laser beam, the epitaxial layer being formed on the semiconductor base substrate;
   an electrode formed on the epitaxial layer; and
   a slope section formed in a partial region that includes one or more corners of a resonator end face of a laser structure including the semiconductor base substrate and the epitaxial layer, the one or more corners being on the epitaxial layer side, the resonator end face being orthogonal to a propagation direction of the laser beam, and the slope section being inclined towards a surface of the laser structure, the surface being on the epitaxial layer side.
(10)
   A semiconductor laser device manufactured by a method including:
   preparing a production substrate on a hexagonal-system group III nitride semiconductor substrate having a semi-polar plane, the production substrate having an epitaxial layer that includes a luminous layer of a semiconductor laser device;
   forming a cutting guide groove in a partial region on a surface of the production substrate, the partial region being on a scribe line on a resonator-end-face side of the semiconductor laser device and including one or more corners of the semiconductor laser device, and the cutting guide groove being formed in an extending direction along the scribe line and being V-shaped in cross section when viewed from the extending direction; and
   cutting, along the scribe line, the production substrate in which the cutting guide groove is formed.

The disclosure contains subject matter related to that disclosed in Japanese Priority Patent Application JP 2011-269030 filed in the Japan Patent Office on December 8, 2011, the entire content of which is hereby incorporated by reference.

It should be understood by those skilled in the art that various modifications, combinations, sub-combinations and alterations may occur depending on design requirements and other factors insofar as they are within the scope of the appended claims or the equivalents thereof.

## Claims

1. A method of manufacturing a semiconductor laser device, the method comprising:
preparing a production substrate on a hexagonal-system group III nitride semiconductor substrate having a semi-polar plane, the production substrate having an epitaxial layer that includes a luminous layer of a semiconductor laser device;
forming a cutting guide groove in a partial region on a surface of the production substrate, the partial region being on a scribe line on a resonator-end-face side of the semiconductor laser device and including one or more corners of the semiconductor laser device, and the cutting guide groove being formed in an extending direction along the scribe line and being V-shaped in cross section when viewed from the extending direction; and
cutting, along the scribe line, the production substrate in which the cutting guide groove is formed.

2. The method according to claim 1, wherein the hexagonal-system group III nitride semiconductor substrate is a semiconductor substrate having a semi-polar plane in which a direction realized by inclining a c-axis towards an m-axis at an angle in a range of about 60 to 90 degrees is a normal direction.

3. The method according to claim 2, wherein the hexagonal-system group III nitride semiconductor substrate is a semiconductor substrate having a semi-polar plane in which a direction realized by inclining the c-axis towards the m-axis by about 75 degrees is a normal direction.

4. The method according to claim 2, wherein the cutting guide groove in which a c-plane is exposed on one of two sidewall surfaces is formed, the two sidewall surfaces defining the cutting guide groove and being formed in a direction along the extending direction of the cutting guide groove.

5. The method according to claim 4, wherein there is formed the cutting guide groove in which a ratio between a width of one of the sidewall surfaces in a groove-width direction and a width of the other of the sidewall surfaces in the groove-width direction is offset from a 1:1 ratio.

6. The method according to claim 5, wherein there is formed the cutting guide groove in which a tip of the cutting guide groove in the extending direction is V-shaped when viewed from a surface of the production substrate, the tip being defined by two front-end sidewall faces, one of the two front-end sidewall faces is formed continuously to the one of the sidewall surfaces, the other of the two front-end sidewall faces is formed continuously to the other of the sidewall surfaces, and a ratio between a width of the one of the two front-end sidewall faces in the groove-width direction and a width of the other of the two front-end sidewall faces in the groove-width direction is offset from a 1:1 ratio.

7. The method according to claim 2, wherein the cutting guide groove is formed to extend in an a-axis direction.

8. The method according to claim 1, wherein the cutting guide groove is formed by dry etching.

9. A semiconductor laser device comprising:
a semiconductor base substrate formed of a hexagonal-system group III nitride semiconductor, and having a semi-polar plane;
an epitaxial layer including a luminous layer that forms an optical waveguide of a laser beam, the epitaxial layer being formed on the semiconductor base substrate;
an electrode formed on the epitaxial layer; and
a slope section formed in a partial region that includes one or more corners of a resonator end face of a laser structure including the semiconductor base substrate and the epitaxial layer, the one or more corners being on the epitaxial layer side, the resonator end face being orthogonal to a propagation direction of the laser beam, and the slope section being inclined towards a surface of the laser structure, the surface being on the epitaxial layer side.

10. A semiconductor laser device manufactured by a method comprising:
preparing a production substrate on a hexagonal-system group III nitride semiconductor substrate having a semi-polar plane, the production substrate having an epitaxial layer that includes a luminous layer of a semiconductor laser device;
forming a cutting guide groove in a partial region on a surface of the production substrate, the partial region being on a scribe line on a resonator-end-face side of the semiconductor laser device and including one or more corners of the semiconductor laser device, and the cutting guide groove being formed in an extending direction along the scribe line and being V-shaped in cross section when viewed from the extending direction; and
cutting, along the scribe line, the production substrate in which the cutting guide groove is formed.
